# EUROPEAN PATENT APPLICATION

(11) **EP 1 978 615 A2**
(43) Date of publication of application: **08.10.2008**
(21) Application number: 08004384.7
(22) Date of filing: 10.03.2008
(51) Int. Cl.: H02G 3/22, H02G 11/00, H02G 15/007

(54) **Power cord fixing structure**

(30) Priority: 26.03.2007 JP 2007078706
(71) Applicant: Funai Electric Co., Ltd., Daito-shi Osaka 574-0013 (JP)
(72) Inventor: Fujikawa, Akihiro, Daito-shi, Osaka 574-0013 (JP)
(74) Representative: Erny, Tobias

(57) **Abstract**

As well as forming a notch in a rear extreme of a rib wall protruding integrated with a rail which supports a main substrate, in which is locked a power cord pulled in a right direction across the rail, a rib which presses into a groove of a bush from a left-right direction is provided on a left wall surface of a support portion of a concave portion which houses the bush.

## Description

### FIELD OF THE INVENTION

The present invention relates to a power cord fixing structure which fixes a power cord to a main body of an instrument.

### BACKGROUND OF THE INVENTION

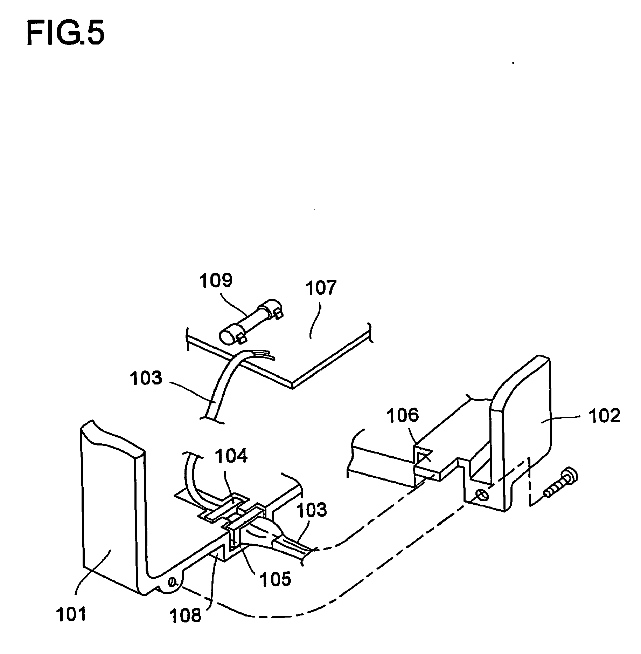

As a heretofore known television set power cord fixing structure, for example, one has been proposed in which, as shown in Fig. 5, while a bush 104 of a power cord 103 is fitted into a concave portion 105, of a shape corresponding to the bush 104, formed in a place in a vicinity of an edge of a side of a front cabinet 101 which is connected to a rear cabinet 102, a protruding piece 106 for, in a condition in which the bush 104 of the power cord 103 is fitted into the concave portion 105, covering this portion, is provided on an edge of a side of the rear cabinet 102 which is connected to the front cabinet 101 (refer to Utility Model Registration No. 3060952). One extreme of the power cord 103 is connected on a main substrate 107 installed approximately horizontally in a vicinity of a bottom surface of the rear cabinet 102.

In this heretofore known power cord fixing structure, as in Fig. 5, by forming an enclosure 108 in such a way as to jut out below a bottom surface of the front cabinet 101, and forming the concave portion 105 on an inner side of the enclosure 108, a depth of the concave portion 105 is secured to a certain extent.

However, there has been a case in which, it not being possible, due to a restriction in a design of the front cabinet 101, to secure a sufficient depth of the concave portion 105, the depth of the concave portion 105 is reduced to around two-thirds of a height of the bush 104, and a gap is formed between a top surface of the concave portion 105 and a height position of the protruding piece 106. In this case, as a holding force of side wall surfaces of the concave portion 105 is weak, there has been a danger that, when pulling the power cord 103, the bush 104 rises up from the concave portion 105, causing the protruding piece 106 to be elastically deformed upward, and the power cord 103 falls out. In particular, in a case in which it is not possible to secure a long distance between a connection site of the power cord 103 on the main substrate 107 and the concave portion 105 of the front cabinet 101, when the power cord 103 looped between them extends due to an elastic restoring force, it comes into contact with a fuse 109 mounted on the main substrate 107, and there has been a problem with safety.

### SUMMARY OF THE INVENTION

The invention, being contrived bearing in mind the heretofore described problems, has an object of providing a power cord fixing structure which, even in the event that a concave portion of a cabinet which meshes with a bush of a power cord is shallow, can prevent the power cord from easily falling out.

In order to achieve the heretofore described object, a power cord fixing structure of the invention includes a front cabinet; a rear cabinet which, together with the front cabinet, configures a casing; a power cord which, including a bush in a predetermined position, is pulled from an interior of the casing to an exterior; a main substrate to which, as well as one extreme of the power cord being connected, a fuse is attached in a vicinity of a connection portion thereof; a pair of rails protruding, opposed on a left and right, integrated with an inner surface of the front cabinet, which support the main substrate by left and right extremes of the main substrate being inserted therein; and a concave portion which houses the bush of the power cord, formed in a position, adjacent to one of the rails, in a vicinity of an edge of a side of the front cabinet which is connected to the rear cabinet. In the power cord fixing structure, the power cord pulled in a left-right direction from the connection portion on the main substrate, across one of the rails, is looped backward, and the bush is housed in the concave portion and, as well as forming a notch in a rear extreme of a rib wall protruding integrated with one of the rails, in which is inserted the power cord pulled in the left-right direction across the rail, a rib which forces the bush in the left-right direction is provided on at least one of left and right wall surfaces of the concave portion.

According to the power cord fixing structure, as the power cord pulled in the left-right direction from the connection portion on the main substrate, across one of the rails, is inserted and locked into the notch, it is possible to carry out a positioning of the power cord in a front-back direction and an up-down direction. Also, by the rib provided on at least one of the left and right wall surfaces of the housing portion forcing the bush in the left-right direction along with the bush of the power cord fitting into the housing portion, it is possible to securely fix the bush in the housing portion.

Also, in the power cord fixing structure of the invention, the rib is provided only on a wall surface, of the left and right wall surfaces of the concave portion, which is nearer to the main substrate.

According to the power cord fixing structure, it is possible to arrange in such a way that, it being necessary to loop the power cord, which is pulled in the left-right direction from the connection portion on the main substrate, across the rail, to the rear when housing the bush of the power cord in the housing portion, a force with which the rib forces the bush in the left-right direction does not act against a force with which the looped power cord attempts to extend due to an elastic restoring force.

Also, in the power cord fixing structure of the invention, the rib is provided on each of the left and right wall surfaces of the concave portion.

According to the power cord fixing structure, the bush of the power cord being sandwiched by a pair of ribs provided on the left and right wall surfaces of the concave portion, it is possible to more securely fix the bush in the housing portion.

Also, in the power cord fixing structure of the invention, in a condition in which the bush of the power cord is housed in the concave portion, a protruding piece which covers this portion is provided on an edge of a side of the rear cabinet which is connected to the front cabinet.

According to the power cord fixing structure, the protruding piece of the rear cabinet being in a condition in which it holds the bush of the power cord, housed in the housing portion, down from above, a prevention of the bush falling out from the housing portion is reliably achieved.

### BRIEF DESCRIPTION OF THE DRAWINGS

Fig. 1 is an exploded perspective view showing a television set according to an embodiment of the invention;
Fig. 2 is a perspective view for illustrating a power cord fixing method in the television set;
Fig. 3 is a perspective view for illustrating the power cord fixing method in the television set;
Fig. 4 is a sectional view for illustrating the power cord fixing method in the television set; and
Fig. 5 is a perspective view showing a heretofore known power cord fixing structure.

### DETAILED DESCRIPTION OF THE PREFERRED EMBODIMENTS

A description will be given, referring to the drawings, of an embodiment of the invention.

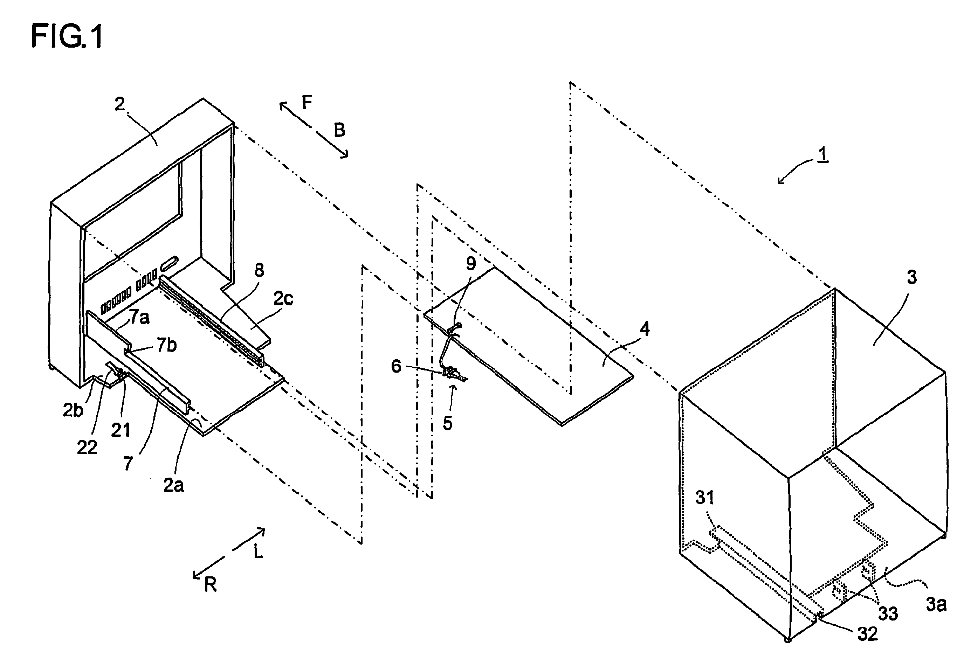

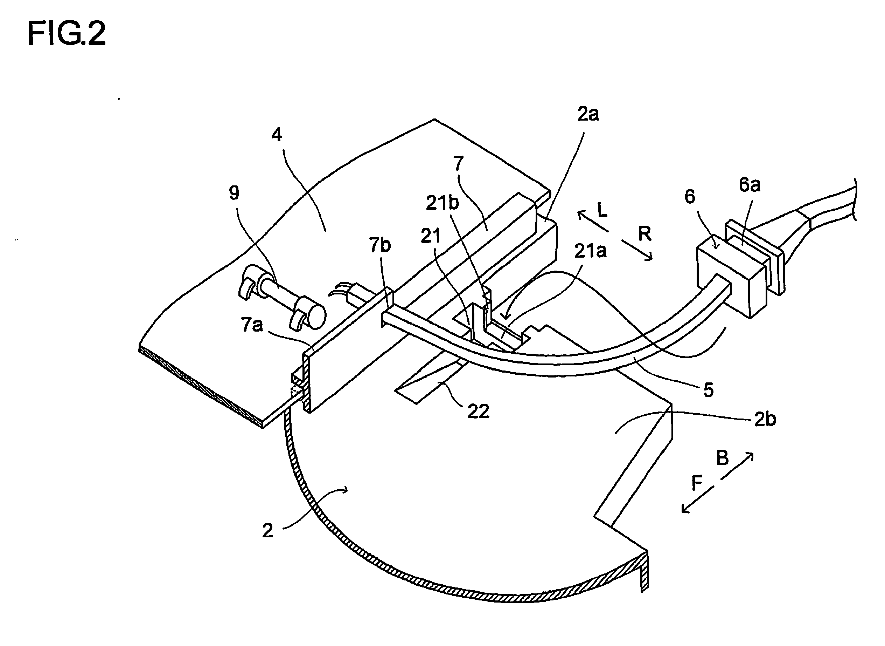

Fig. 1 is an exploded perspective view showing a television set according to the embodiment of the invention. Fig. 2 is a perspective view for illustrating a power cord fixing method in the television set.

A television set 1, as shown in Fig. 1, includes a plastic front cabinet 2, a plastic rear cabinet 3 which, together with the front cabinet 2, configures a casing, and a printed circuit board (hereafter called a "main substrate") 4, which carries out a control of the television set 1. In the embodiment, the front cabinet 2 configures a front surface and a greater part of a bottom surface of the television set 1, while the rear cabinet 3 configures a top surface, both side surfaces, a back surface and the remaining portion of the bottom surface of the television set 1.

A power cord 5, for supplying electric power to the main substrate 4, is connected to an extreme of a right-hand side (a direction of an arrow R), at a front (a direction of an arrow F) of the main substrate 4. As shown in Fig. 2, the power cord 5 has a plastic bush 6, in a periphery of which a groove 6a is formed. A fuse 9 is attached in a vicinity of a connection portion of the power cord 5 on the main substrate 4. A rear extreme of the main substrate 4 is positioned by being held by clamping ribs 33, formed integrated with an inner surface of a back surface of the rear cabinet 3.

The front cabinet 2 having a bottom surface portion 2a which protrudes toward a rear (in a direction of an arrow B), as shown in Fig. 2, a pair of rails 7 and 8 which support the main substrate 4 protrude, opposed on a left and right, integrated with an inner surface of the bottom surface portion 2a. A rib wall 7a protruding integrated with a front portion (the direction of the arrow F) of the rail 7, so as to be flush with a side surface of a right-hand side (the direction of the arrow R) of the rail 7, a notch 7b, having a size sufficient that the power cord 5 can be inserted therein, is formed in a rear extreme (the direction of the arrow B) of the rib wall 7a.

Left and right side portions of the bottom surface portion 2a of the front cabinet 2 are cut away to leave fin-shaped portions 2b and 2c adjacent to the rails 7 and 8 respectively. Meanwhile, a bottom surface portion 3a of the rear cabinet 3 has a flat form, from which a portion corresponding to this kind of bottom surface portion 2a of the front cabinet 2 is cut away. For this reason, when the casing of the television set 1 is assembled, an edge of a rear (the direction of the arrow B) of the bottom surface portion 2a of the front cabinet 2 and an edge of a front (the direction of the arrow F) of the bottom surface portion 3a of the rear cabinet 3 being connected, the bottom surface of the television set 1 is configured of both bottom surface portions 2a and 3a.

As shown in Fig. 2, a housing portion (a concave portion) 21 is formed in a position adjacent to the rail 7 at a rear (the direction of the arrow B) extreme of the fin-shaped portion 2b of the front cabinet 2. The housing portion 21 being provided, as shown in Fig. 2, to house the bush 6 of the power cord 5, it is formed in a shape corresponding to the bush 6 of the power cord 5. A support portion 21a, which fits into the groove 6a of the bush 6, is formed in the housing portion 21. Furthermore, a rib 21b, which presses into the groove 6a of the bush 6, is formed on a left wall surface of the support portion 21a. By this means, the bush 6 being forced to a right-hand side (the direction of the arrow R), a prevention of its falling out from the housing portion 21 is achieved.

In the embodiment, the rib 21b is provided only on the left wall surface which, of left and right wall surfaces of the support portion 21a, is the wall surface nearer to the main substrate 4. This is in order that, as it is necessary to loop the power cord 5, which is pulled to the right-hand side (the direction of the arrow R) from the connection portion on the main substrate 4, across the rail 7, to the rear (the direction of the arrow B) when housing the bush 6 of the power cord 5 in the housing portion 21, a force with which the rib 21b forces the bush 6 in a left-right direction does not act against a force with which the looped power cord 5 attempts to extend due to an elastic restoring force. However, even supposing that the same kind of rib is provided only on the right wall surface of the support portion 21a, it will be sufficiently effective in preventing the bush 6 from falling out. To go further, by providing the same kind of rib on both the left and right wall surfaces of the support portion 21a, the groove 6a of the bush 6 being sandwiched left and right by a pair of ribs, it is possible to more securely fix the bush 6 in the housing portion 21.

A guide groove 22 is formed continuing on from a front (the direction of the arrow F) of the housing portion 21. The guide groove 22 is formed in a kind of shape which becomes deeper as it nears the housing portion 21. By this means, when housing the bush 6 in the housing portion 21, it is possible to suppress a bending of the power cord 5 in a vicinity of the bush 6.

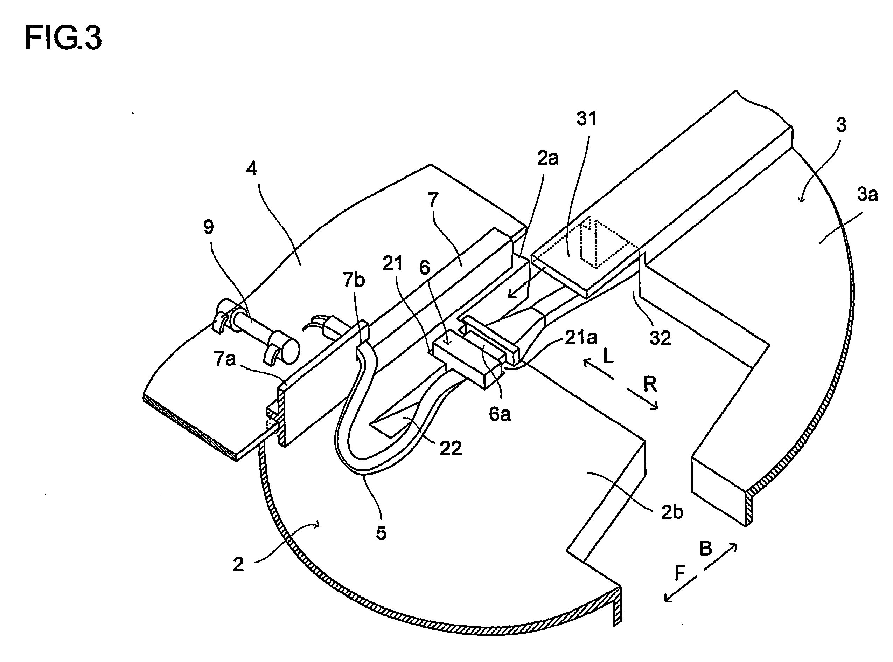

A protruding piece 31, corresponding to the housing portion 21, is provided in the rear cabinet 3. As shown in Fig. 3, the protruding piece 31 is formed integrated with the rear cabinet 3, in such a way as to protrude extending from the inner surface of the back surface of the rear cabinet 3 toward the front cabinet 2 (the direction of the arrow F). The protruding piece 31 is provided in order to hold the bush 6 of the power cord 5 down from above. As shown in Fig. 3, an outlet portion 32 is formed below the protruding piece 31. The outlet portion 32 is provided in order to pull (let out) the power cord 5 from an interior of the television set 1 to an exterior.

Next, a description will be given of a method of fixing the power cord 5 in the television set 1 according to the embodiment. Firstly, the main substrate 4 shown in Fig. 2 is moved to the front (the direction of the arrow F), and fitted into the pair of rails provided on the bottom surface portion 2a of the front cabinet 2. Herein, the bush 6 is moved to the housing portion 21 by inserting the power cord 5 attached to the main substrate 4 into the notch 7b and, after once bending it forward at an edge of the notch 7b, looping it backward. By this means, as the power cord 5, which is pulled to the right-hand side (the direction of the arrow R) from the connection portion on the main substrate 4, across the rail 7, is inserted and locked into the notch 7b, it is possible to carry out a positioning of the power cord 5 in a front-back direction and an up-down direction.

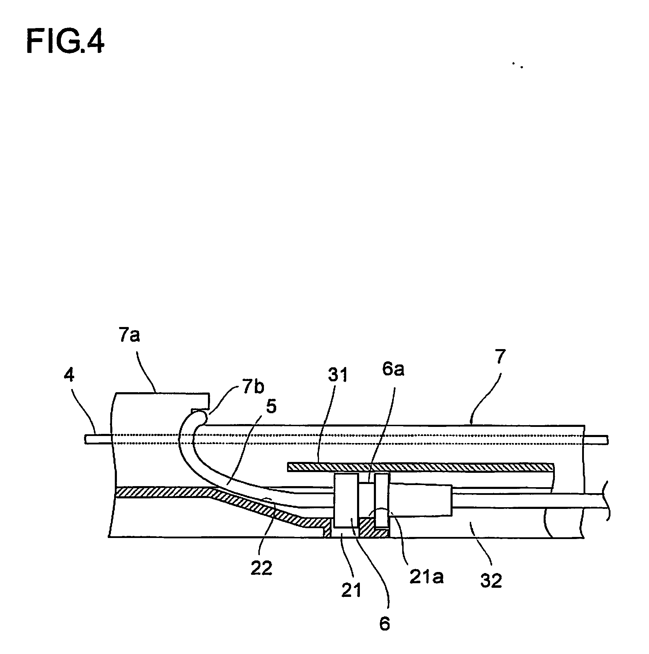

Then, the bush 6 of the power cord 5 is housed inside the housing portion 21 by moving it from above the housing portion 21. At this time, as shown in Fig. 3, it is possible to securely fix the bush 6 in the housing portion 21 because, as well as the support portion 21a of the housing portion 21 fitting inside the groove 6a of the bush 6, the rib 21b provided on the support portion 21a forces the groove 6a of the bush 6 to the right-hand side (the direction of the arrow R). Then, the rear cabinet 3 is fitted in from a rear of the front cabinet 2 shown in Fig. 1. By this means, as shown in Fig. 4, a bottom surface of the protruding piece 31 of the rear cabinet 3 being in a condition in which it holds the bush 6 of the power cord 5, housed in the housing portion 21, down from above, the prevention of the bush 6 falling out from the housing portion 21 is reliably achieved.

The heretofore described embodiment, being illustrative in all aspects, is not limiting. For example, in the heretofore described embodiment, the description has been given with the television set as an example but, the invention not being limited to this, it can also be applied to a television set integrated with a video player or DVD player, or the like, including a video deck or DVD drive device, as long as it includes a power cord.

## Claims

1. A power cord fixing structure, comprising:
a front cabinet;
a rear cabinet which, together with the front cabinet, configures a casing;
a power cord which, including a bush in a predetermined position, is pulled from an interior of the casing to an exterior;
a main substrate to which, as well as one extreme of the power cord being connected, a fuse is attached in a vicinity of a connection portion thereof;
a pair of rails protruding, opposed on a left and right, integrated with an inner surface of the front cabinet, which support the main substrate by left and right extremes of the main substrate being inserted therein; and
a concave portion which houses the bush of the power cord, formed in a position, adjacent to one of the rails, in a vicinity of an edge of a side of the front cabinet which is connected to the rear cabinet, wherein
the power cord pulled in a left-right direction from the connection portion on the main substrate, across one of the rails, is looped backward, and the bush is housed in the concave portion, and
as well as forming a notch in a rear extreme of a rib wall protruding integrated with one of the rails, in which is inserted the power cord pulled in the left-right direction across the rail, a rib which forces the bush in the left-right direction is provided on at least one of left and right wall surfaces of the concave portion.

2. The power cord fixing structure according to claim 1, wherein
the rib is provided only on a wall surface, of the left and right wall surfaces of the concave portion, which is nearer to the main substrate.

3. The power cord fixing structure according to claim 1, wherein
the rib is provided on each of the left and right wall surfaces of the concave portion.

4. The power cord fixing structure according to claim 1 or 2, wherein
in a condition in which the bush of the power cord is housed in the concave portion, a protruding piece which covers this portion is provided on an edge of a side of the rear cabinet which is connected to the front cabinet.
